Europäisches Patentamt

European Patent Office

Office européen des brevets

(11) Publication number: **0 249 413 B1**

(12) **EUROPEAN PATENT SPECIFICATION**

(45) Date of publication of patent specification: **11.05.94** (51) Int. Cl.⁵: **G11C 8/00**, G11C 7/00

(21) Application number: **87304997.7**

(22) Date of filing: **05.06.87**

(54) **Semiconductor memory device.**

(30) Priority: **06.06.86 JP 131443/86**

(43) Date of publication of application:
**16.12.87 Bulletin 87/51**

(45) Publication of the grant of the patent:
**11.05.94 Bulletin 94/19**

(84) Designated Contracting States:
**DE FR GB**

(56) References cited:
**EP-A- 0 068 893**
**EP-A- 0 165 612**
**WO-A-80/00632**
**GB-A- 2 091 008**

(73) Proprietor: **FUJITSU LIMITED**
**1015, Kamikodanaka**
**Nakahara-ku**
**Kawasaki-shi Kanagawa 211(JP)**

(72) Inventor: **Ohira, Tsuyoshi**
**Fudogaoka Haitsu 102 926 Shimosakunobe**
**Takatsu-ku**
**Kawasaki-shi Kanagawa 211(JP)**
Inventor: **Nakano, Tomio**
**1-27-103, Sugesengoku 3-chome**
**Tama-ku**
**Kawasaki-shi Kanagawa 214(JP)**

(74) Representative: **Fane, Christopher Robin King
et al
HASELTINE LAKE & CO.
Hazlitt House
28 Southampton Buildings
Chancery Lane
London, WC2A 1AT (GB)**

## Description

The present invention relates to a semiconductor memory device which may be used, for example, in a dynamic random access memory.

In previously-proposed semiconductor memory devices, a memory cell array is sometimes constituted by a plurality of memory cell blocks.

In such devices, it is possible to keep the memory cell blocks which do not include the selected word line in the inactive state so that the consumption of electric power of the device is reduced.

However, in some such previously-proposed devices, only some of the memory cell blocks are kept in the inactive state due to a non-selection thereof, and the clock generator which is provided in common for the plurality of memory cell blocks is always in operation to supply clock signals such as word line activation clock signals to all of the plurality of memory cell blocks. Hence, the reduction of the electric power consumption may not be satisfactorily attained in such devices.

With a view to overcoming this disadvantage of the prior art, the applicants previously proposed in EP-A-0068893 that an independently-operable clock generating circuit be provided for each memory cell block. In particular, EP-A-0068893 discloses a semiconductor memory device comprising: an array of memory cells divided into a plurality of memory cell blocks; a plurality of row selection circuits operatively connected to respective memory cell blocks and arranged to receive an address signal indicative of a memory cell to be accessed during an accessing operation; column decoder circuitry operatively connected to said plurality of memory cell blocks and arranged to receive the said address signal; the row selection circuit which is associated with the memory cell block containing the memory cell to be accessed and said column decoder circuitry being operable, upon receipt respectively of a row selection circuit activation signal and a column decoder activation signal, to select respectively, in accordance with said address signal, a row and a column within said memory cell block; clock signal generating means connected to said row selection circuits and said column decoder circuitry and operable to generate said row selection circuit activation signal and said column decoder activation signal, which means include a plurality of clock signal generating circuits connected to respective row selection circuits and selectively operable individually to produce said row selection circuit activation signal and to supply that signal to the row selection circuit associated therewith; and block selection means connected to each of said clock signal generating circuits and arranged to receive said address signal, said means being operable at the commencement of an accessing operation to select, in dependence upon that address signal, that one of the clock signal generating circuits which serves the row selection circuit associated with the memory cell block to which the memory cell to be accessed belongs, which clock signal generating circuit is thereby caused to deliver said row selection circuit activation signal to the row selection circuit associated therewith, so activating during said accessing operation only that one of the row selection circuits which is associated with the memory cell block containing the memory cell to be accessed. However, it is desirable to reduce the power consumption of such of a device still further.

An additional difficulty, in a large capacity semiconductor memory device, having a chip size of the order of 10 mm$^2$ or more, is that the length of the wiring for transmitting clock signals becomes large and accordingly, the parasitic capacitance of the wiring becomes large, so that a high speed operation of the device may be difficult to attain. Also the consumption of electric power can become large, and an IR drop caused by the resistance of the wiring can become significant.

According to the present invention there is provided a semiconductor memory device comprising: an array of memory cells divided into a plurality of memory cell blocks; a plurality of row selection circuits operatively connected to respective memory cell blocks and arranged to receive an address signal indicative of a memory cell to be accessed during an accessing operation; column decoder circuitry operatively connected to said plurality of memory cell blocks and arranged to receive the said address signal; the row selection circuit which is associated with the memory cell block containing the memory cell to be accessed and said column decoder circuitry being operable, upon receipt respectively of a row selection circuit activation signal and a column decoder activation signal, to select respectively, in accordance with said address signal, a row and a column within said memory cell block; clock signal generating means connected to said row selection circuits and said column decoder circuitry and operable to generate said row selection circuit activation signal and said column decoder activation signal, which means include a plurality of clock signal generating circuits connected to respective row selection circuits and selectively operable individually to produce said row selection circuit activation signal and to supply that signal to the row selection circuit associated therewith; and block selection means connected to each of said clock signal generating circuits and arranged to receive said address signal, said means being operable at the commencement of an accessing operation to select, in dependence upon that address signal that one of the clock signal generating circuits which serves the row selection circuit associated with the memory cell block to which the memory cell to be accessed belongs, which clock signal generating circuit is thereby caused to deliver said row selection circuit activation signal to the row selection circuit associated therewith, so activating during said accessing operation only that one of the row selection circuits which is associated with the memory cell block containing the memory cell to be accessed; characterised in that said column decoder circuitry comprises a plurality of column decoders connected to respective memory cell blocks, and in that said clock signal generating circuits are also connected respectively to the column decoders such that each such circuit is connected to the column decoder and row selection circuit associated with the same memory cell block, and are operable individually, when selected by said block selection means, to produce said column decoder activation signal and to supply that signal to the column decoder associated therewith.

In the device of EP-A-0068893, a pair of memory cell blocks sharing a common column decoder are provided, the clock signal circuitry serving the column decoder being separate from that serving the row selection circuits. In contrast, in a device embodying the present invention, each memory cell block has its own column decoder which is controlled by the clock signal generating circuit associated with the row selection circuit for that block. Since only the column decoder for the memory cell block containing the memory cell to be accessed is activated, power consumption in the device is reduced as compared to that in the device of EP-A-0068893.

Reference will now be made, by way of an example, to the accompanying drawings, in which:

Fig. 1 shows a previously-proposed semiconductor memory device;

Fig. 2 shows a structure of a clock generator in the device of Fig. 1;

Fig. 3 shows a semiconductor memory device embodying the present invention;

Fig. 4 shows the structure of a clock generator in the device of Fig. 3;

Fig. 5 shows the structure of a block selector in the device of Fig. 3;

Fig. 6 shows the structures of a row decoder and word driver in the device of Fig. 3; and

Fig. 7 shows a modified device embodying the present invention.

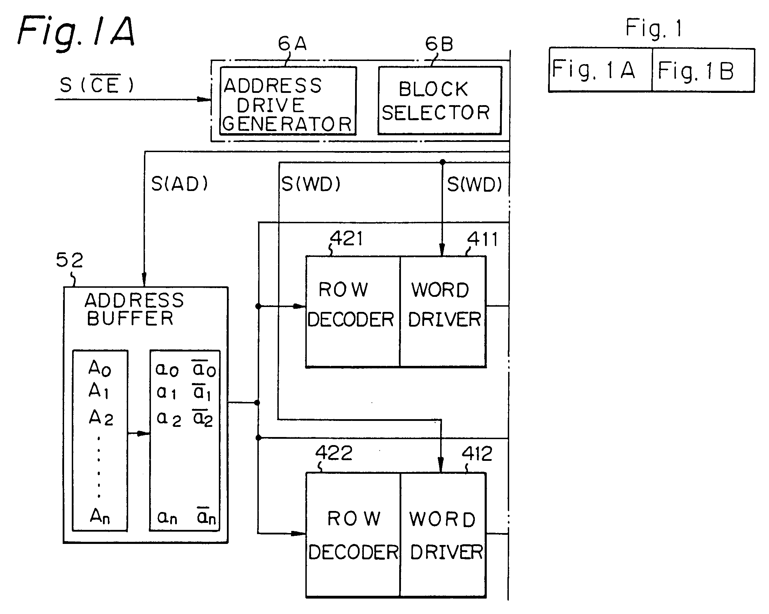

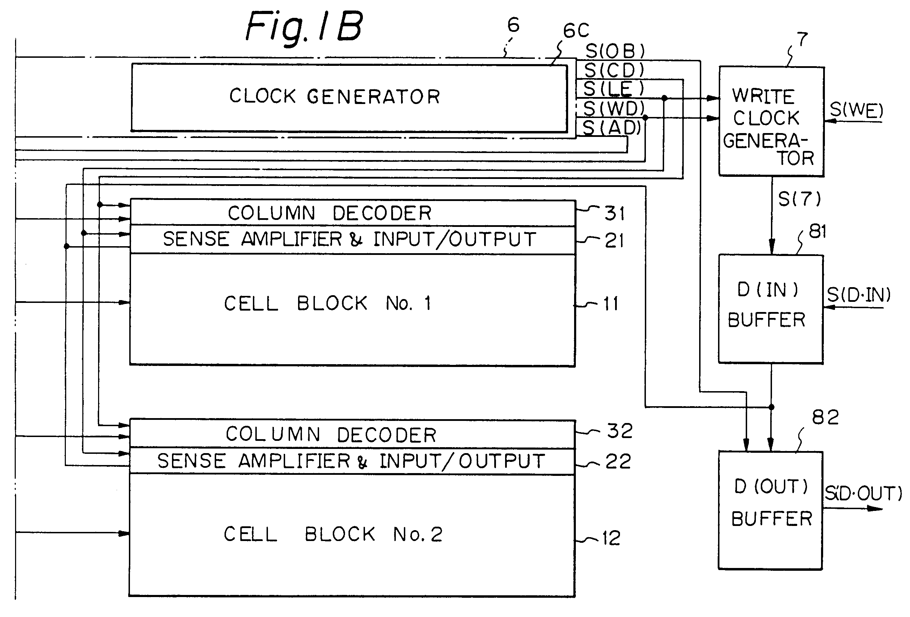

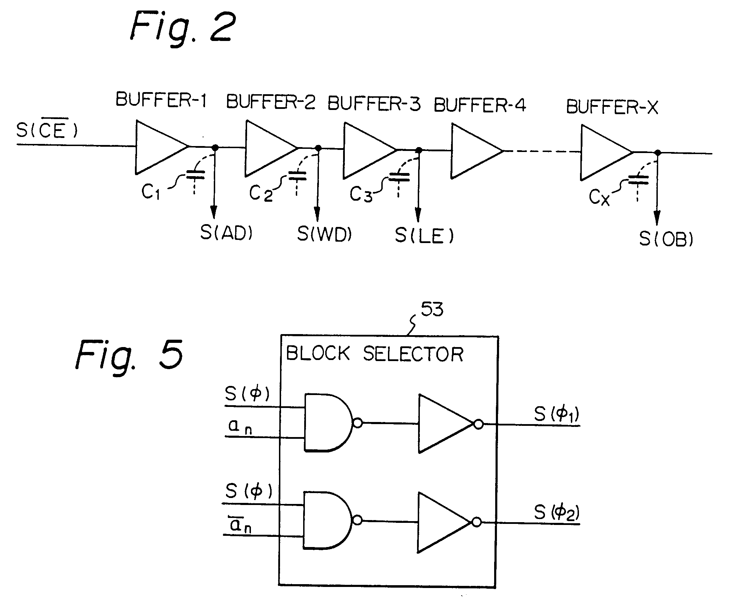

Before describing a typical embodiment of the present invention, a previously-proposed semiconductor memory device will be explained with reference to Figs. 1 and 2. The structure of the clock generator in the device of Fig. 1 is shown in Fig. 2.

The device of Fig. 1 is constructed by a No. 1 memory cell block 11, No. 2 memory cell block 12, word drivers 411, 412, row decoders 421, 422, sense amplifier and input/output circuits 21, 22, column decoders 31, 32, clock generation portion 6 having an address drive generator 6A, block selector 6B and clock generator 6C, write clock generator 7, data input buffer 81, and data output buffer 82.

The clock generation portion 6 receives a chip activation signal $S(\overline{CE})$, and a clock signal $S(AD)$ from the clock generation portion 6 is supplied to the address buffer 52. The external address bits $A_0$, $A_1$, $A_2$, ... $A_n$ are latched in the address buffer 52. In the address buffer 52, the MOS level address bits $a_0$, $a_1$, $a_2$, ... $a_n$ and the inverted MOS level address bits $\overline{a_0}$, $\overline{a_1}$, $\overline{a_2}$ ... $\overline{a_n}$ are produced from the external address bits $A_0$, $A_1$, $A_2$ ... $A_n$, and the produced signals are supplied to the column decoders 31, 32 and the row decoders 421, 422.

A clock signal $S(WD)$ for activating word lines from the clock generation portion 6 is supplied to the word drivers 411 and 412. A clock signal $S(LE)$ for resetting bit lines from the clock generation portion 6 is supplied to the sense amplifier and input/output circuits 21 and 22, to precharge the bit lines.

A clock signal $S(CD)$ for activating bit lines from the clock generation portion 6 is supplied to the column decoders 31 and 32. The write clock generator 7 supplies the write clock signal $S(7)$ to the data input buffer 81 in response to a write enable signal $S(WE)$. The input data $D(IN)$ in the data input buffer 81 is supplied to the sense amplifier and input/output circuits 21 and 22 in accordance with the write clock signal $S(7)$.

The clock generator 6C includes a sequence of buffers: BUFFER-1, BUFFER-2, BUFFER-3, ... BUFFER-X. Each of the buffers produces a predetermined clock signal such as $S(AD)$, $S(WD)$, $S(LE)$, $S(OB)$ or the like with a predetermined delay time.

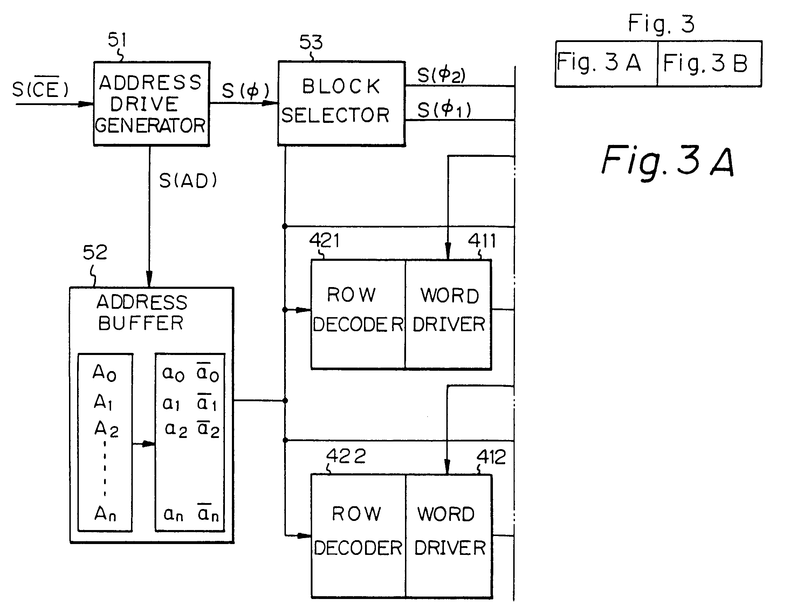

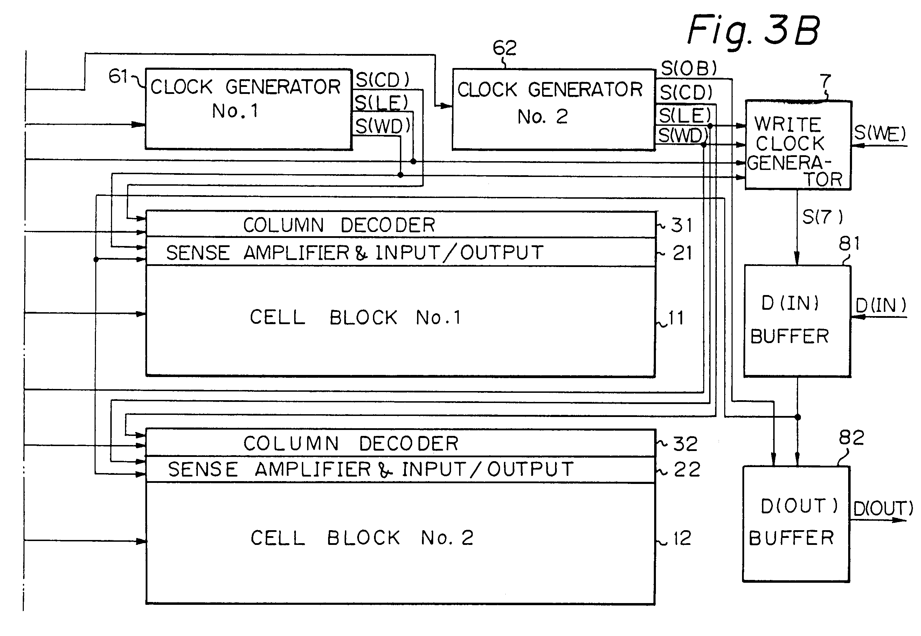

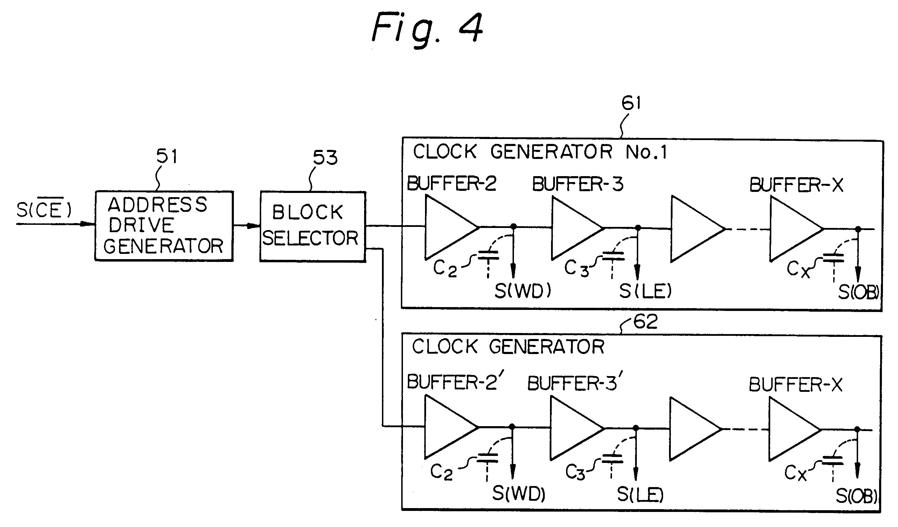

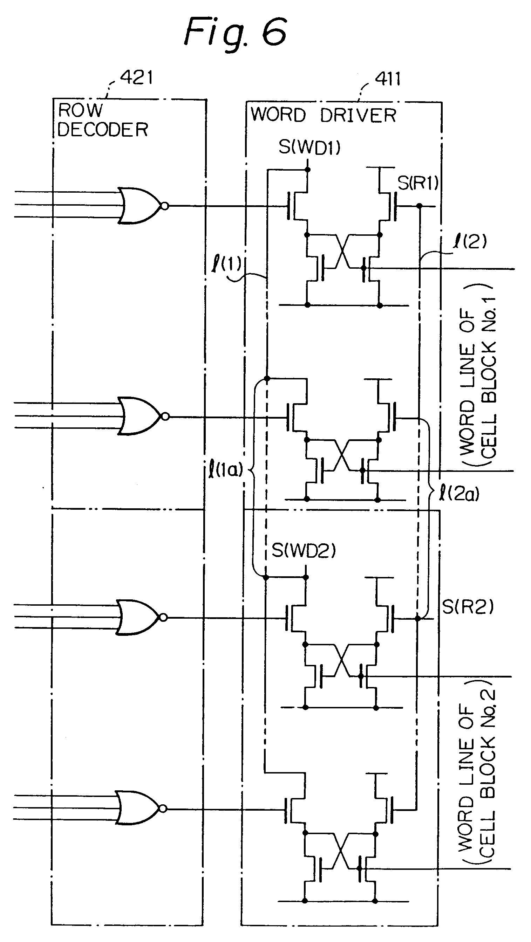

A semiconductor memory device embodying the present invention is shown in Fig. 3. The structures of the clock selector and the block selector in the device of Fig. 3 are shown in Figs. 4 and 5, respectively.

The semiconductor memory device of Fig. 3 is constructed from a No. 1 memory cell block 11, No. 2 memory cell block 12, word drivers 411, 412, row decoders 421, 422, sense amplifier and input/output circuits 21, 22, column decoders 31, 32, address drive generator 51, address buffer 52, block selector 53, No. 1 clock generator 61, No. 2 clock generator 62, write clock generator 7, data input buffer 81, and data output buffer 82.

The address drive generator 51 receives the chip activation signal S($\overline{CE}$), and supplies the clock signal S(AD) to the address buffer 52. The external address bits $A_0$, $A_1$, $A_2$ ... $A_n$ are latched in the address buffer 52. In the address buffer 52, the MOS level address bits $a_0$, $a_1$, $a_2$, ... $a_n$ and the inverted MOS level address bits $\overline{a_0}$, $\overline{a_1}$, $\overline{a_2}$, ... $\overline{a_n}$ are produced from the external address bits $A_0$, $A_1$, $A_2$, ... $A_n$, and the produced signals are supplied to the column decoders 31, 32, and the row decoders 421, 422.

The clock generators 61, 62 are associated with respective ones of the memory cell blocks 11, 12.

Clock signals S(WD) for activating word lines are supplied to the word drivers 411 and 412 by the No. 1 clock generator 61 and the No. 2 clock generator 62 respectively.

Clock signals S(LE) for resetting bit lines are supplied by the clock generators 61 and 62 to the sense amplifier and input/output circuits 21 and 22 respectively to precharge the bit lines.

Clock signals S(CD) for activating bit lines are supplied to the column decoders 31 and 32 from the clock generators 61 and 62 respectively.

The write clock generator 7 supplies the write clock signal S(7) to the data input buffer 81 in response to a write enable signal S(WE). The input data D(IN) in the data input buffer 81 is supplied to the sense amplifier and input/output circuits 21 and 22 in accordance with the write clock signal S(7).

The block selector 53 receives from the address buffer 52 a signal S($\phi$) representing a portion of the row address, for example, the uppermost bit of the row address, and selects either the No. 1 clock generator 61 by supplying a signal S($\phi_1$) thereto or the No. 2 clock generator 62 by supplying a signal S($\phi_2$) thereto in accordance with the information of the portion of the row address.

In the operation of the device of Fig. 3, both the row decoders 412 and 422 are activated. However, only one of the word drivers 411 and 412 is activated in accordance with the selection between the No. 1 clock generator 61 and the No. 2 clock generator 62.

The structure of the No. 1 and No. 2 clock generators is shown in Fig. 4, and the structure of the block selector 53 is shown in Fig. 5.

As shown in Fig. 4, the No. 1 clock generator 61 includes the series connected buffers: BUFFER-2, BUFFER-3, BUFFER-4, and so on. Each of these buffers operates with a predetermined delay time. The No. 2 clock generator 62 includes similar series connected buffers.

As shown in Fig. 5, the block selector 53 is constructed from a series connection of a NAND gate and an inverter. One input terminal of the NAND gate receives the signal S($\phi$) from the ad-dress drive generator, while the other input terminal receives address bits $a_n$ and $\overline{a_n}$ from the address buffer 52. The address bits $a_n$ and $\overline{a_n}$ are the MOS level address bits converted from the external address $A_n$. When $A_n$ is at a HIGH level, $a_n$ is at a HIGH level, and $\overline{a_n}$ is at a LOW level. The selection signal S($\phi_1$) or S($\phi_2$) is delivered from one of the inverters of the block selector 53.

The characteristic of the capacitance distribution in the word driver 411 in the device of Fig. 3 will be explained with reference to Fig. 6, which shows the structures of the row decoder 421 and the word driver 411 in the device of Fig. 3. The word driver 411 is constructed from flip-flop circuits.

The signal S(WD1) and the signal S(WD2) are supplied as a power source voltage to one branch of the flip-flop circuits. The outputs of the row decoder 421 are supplied to the gates of the transistors in the one branch of the flip-flop circuits. The reset clock signals S(R1) and S(R2) are supplied to the gates of the transistors in the other branch of the flip-flop circuits.

In the word driver 411 of the device of Fig. 3, the portions $\ell$(1a) and $\ell$(2a) of the wirings $\ell$(1) and $\ell$(2) do not exist. Since there are no wirings of the portions $\ell$(1a) and $\ell$(2a), the parasitic capacitance of the entire wiring is reduced accordingly. Therefore, the entire parasitic capacitance of the wirings is reduced in the device of Fig. 3. Accordingly, the operation speed of the device is enhanced and the consumption of electric power is reduced in the device of Fig. 3.

Contrary to this, if the portions $\ell$(1a) and $\ell$(2a) exist as in the case of the prior art device, a considerably large parasitic capacitance of the wiring is formed, and this formed parasitic capacitance is added to the drain capacitances of the transistors of the flip-flop circuits in the word driver. This large capacitance requires a considerably large capacity of the power source, and constitutes a disadvantage of the prior art.

In the device of Fig. 3, the parasitic capacitances of the wirings for transmitting the signals S-(WD), S(LE), and the like from the clock generators 61 and 62 (Fig. 4) are reduced, and thus the charge/discharge current is reduced, and the time of charge/discharge is reduced. Also, the capacity requirement for the buffers: BUFFER-2, BUFFER-3, etc., is reduced. Only one of the clock generators is required to operate so that the consumption of electric power is reduced.

Although a typical embodiment of the present invention is explained with reference to Figs. 3 to 6 in which the division by 2 of the cell blocks is realized, other embodiments of the present invention are possible in which the division by 4, 8, 16, or the like of the cell blocks is realized.

Also, although in the device of Fig. 3 the division is realized only in the row decoder side, it is also possible to realize the division not only in the row decoder side but also in the column decoder and input-output side. The clock generator should be divided in correspondence with such division in the column decoder and input-output circuit side.

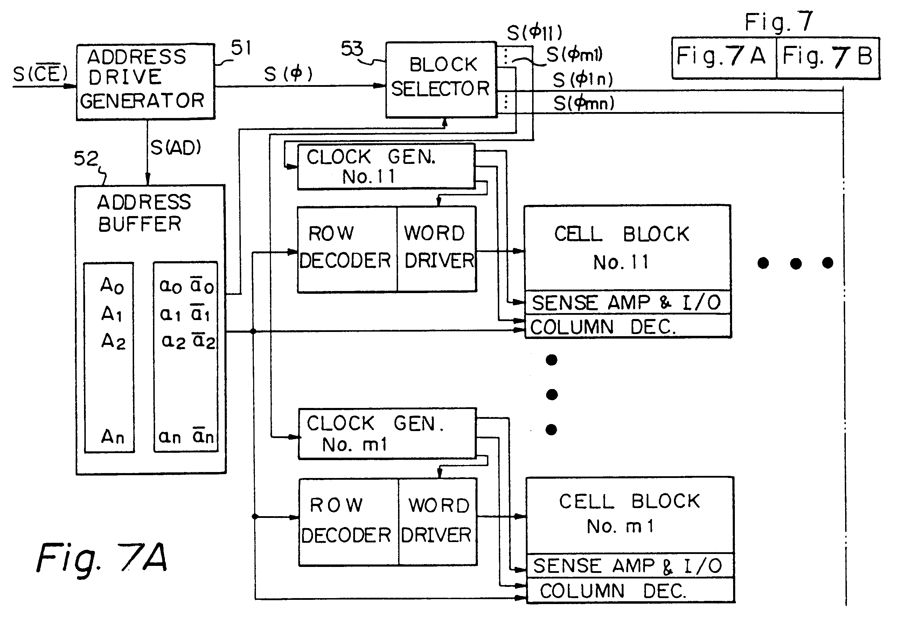

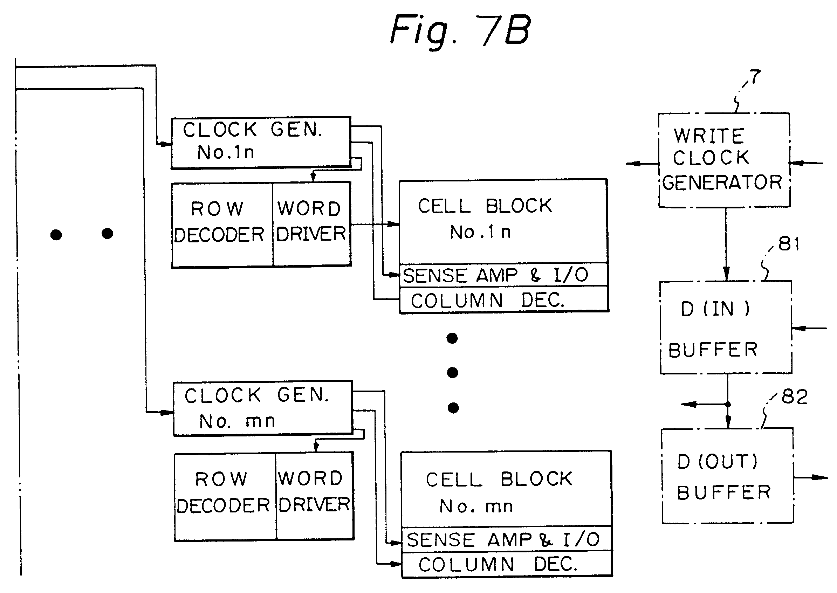

A semiconductor memory device according to a modified embodiment of the present invention is shown in Fig. 7. In the device of Fig. 7, the memory cell block is divided into m divisions along the row direction and n divisions along the column direction, to consequently attain m x n divisions.

The block selector 53 delivers the clock signals $S(\phi_{11})$, $S(\phi_{21})$, ... $S(\phi_{m1}$; $S(\phi_{12})$, $S(\phi_{22})$, ... $S(\phi_{m2})$;... $S(\phi_{1n})$, $S(\phi_{2n})$, ... $S(\phi_{mn})$ which are supplied to the clock generators No. 11, No. 21, ... No. m1; No. 12, No. 22, ... No. m2; ...; No. 1n, No. 2n, ... No. mn. For example, the No. 11 clock generator delivers the signals for the No. 11 cell block, and the No. mn clock generator delivers the signal for the No. mn cell block.

**Claims**

1. A semiconductor memory device comprising:

an array of memory cells divided into a plurality of memory cell blocks (11; 12);

a plurality of row selection circuits (411,421; 412,422) operatively connected to respective memory cell blocks (11; 12) and arranged to receive an address signal $(a_0,...,a_n)$ indicative of a memory cell to be accessed during an accessing operation;

column decoder circuitry (31,32) operatively connected to said plurality of memory cell blocks (11; 12) and arranged to receive the said address signal $(a_0,...,a_n)$;

the row selection circuit (411,421; 412,422) which is associated with the memory cell block (11; 12) containing the memory cell to be accessed and said column decoder circuitry (31,32) being operable, upon receipt respectively of a row selection circuit activation signal (S(WD)) and a column decoder activation signal (S(CD)), to select respectively, in accordance with said address signal $(a_0,...,a_n)$, a row and a column within said memory cell block (11; 12);

clock signal generating means (61,62) connected to said row selection circuits (411,421; 412,422) and said column decoder circuitry (31,32) and operable to generate said row selection circuit activation signal (S(WD)) and said column decoder activation signal (S(CD)), which means (61,62) include a plurality of clock signal generating circuits (61; 62) connected to respective row selection circuits (411,421; 412,422) and selectively operable individually to produce said row selection circuit activation signal (S(WD)) and to supply that signal (S(WD)) to the row selection circuit (411,421; 412,422) associated therewith; and

block selection means (53) connected to each of said clock signal generating circuits (61; 62) and arranged to receive said address signal $(a_0,...,a_n)$, said means being operable at the commencement of an accessing operation to select, in dependence upon that address signal $(a_0,...,a_n)$, that one of the clock signal generating circuits (61; 62) which serves the row selection circuit (411,421; 412,422) associated with the memory cell block (11; 12) to which the memory cell to be accessed belongs, which clock signal generating circuit (61; 62) is thereby caused to deliver said row selection circuit activation signal (S(WD)) to the row selection circuit (411,421; 412,422) associated therewith, so activating during said accessing operation only that one of the row selection circuits (411,421; 412,422) which is associated with the memory cell block (11; 12) containing the memory cell to be accessed;

characterised in that said column decoder circuitry (31,32) comprises a plurality of column decoders (31; 32) connected to respective memory cell blocks ((11; 12), and in that said clock signal generating circuits (61; 62) are also connected respectively to the column decoders (31; 32), such that each such circuit (61; 62) is connected to the column decoder (31; 32) and row selection circuit (411,421; 412,422) associated with the same memory cell block (11; 12), and are operable individually, when selected by said block selection means (53), to produce said column decoder activation signal (S(CD)) and to supply that signal (S(CD)) to the column decoder (31; 32) associated therewith.

2. A device as claimed in claim 1, wherein said block selection means (53) are operable to produce a plurality of selection signals $(S(\phi_1)$; $S(\phi_2))$ for delivery respectively to said clock signal generating circuits (61; 62), which selection signals $(S(\phi_1)$; $S(\phi_2))$ are such that only the clock signal generating circuit (61; 62) to be selected is activated.

3. A device as claimed in claim 2, wherein said block selection means (53) comprise a plurality of selection signal generating circuits for respectively providing the said selection signals $(S(\phi_1)$; $S(\phi_2))$, each selection signal generating circuit being constituted by a NAND gate connected in series with an inverter.

4. A device as claimed in claim 3, wherein in each of the selection signal generating circuits said NAND gate has a first input terminal connected to receive an operating signal $(S(\phi))$ from an address drive generator (51) of the device, and a second input terminal connected to receive address bits $(a_0,...,a_n)$ from an address buffer (52) of the device.

5. A device as claimed in any preceding claim, wherein each of said clock signal generating circuits (61; 62) comprises at least two buffers (BUFFER-2, BUFFER-3,...) connected together in series such said row selection circuit activation signal (S(WD)) and column decoder activation signal (S(CD)) are provided at preset times at respective output nodes of the said buffers (BUFFER-2, BUFFER-3,...).

6. A device as claimed in any preceding claim, wherein each of said clock signal generating circuits (61; 62) is also operable to produce clock signals for use in input/output circuitry (81/82) and sense amplifier circuitry (21; 22) of the device.

**Patentansprüche**

1. Eine Halbleiterspeicheranordnung mit:

einem Array von Speicherzellen, die in eine Vielzahl von Speicherzellenblöcken (11; 12) eingeteilt sind;

einer Vielzahl von Reihenauswahlschaltungen (411, 421; 412, 422), die mit entsprechenden Speicherzellenblöcken (11; 12) operativ verbunden sind und angeordnet sind, um ein Adreßsignal $(a_0, ..., a_n)$ zu empfangen, das auf eine Speicherzelle hinweist, auf die während einer Zugriffsoperation zuzugreifen ist;

einer Spaltendekoderschaltungsanordnung (31, 32), die mit der genannten Vielzahl von Speicherzellenblöcken (11; 12) operativ verbunden ist und angeordnet ist, um das genannte Adreßsignal $(a_0, ..., a_n)$ zu empfangen;

wobei die Reihenauswahlschaltung (411, 421; 412, 422), die dem Speicherzellenblock (11; 12) zugeordnet ist, der die Speicherzelle enthält, auf die zuzugreifen ist, und die genannte Spaltendekoderschaltungsanordnung (31, 32) betriebsfähig sind, um bei Empfang eines Reihenauswahlschaltungsaktivierungssignals (S(WD)) bzw. eines Spaltendekoderaktivierungssignals (S(CD)) eine Reihe bzw. eine Spalte innerhalb des genannten Speicherzellenblocks (11; 12) auszuwählen, in Übereinstimmung mit dem genannten Adreßsignal $(a_0, ..., a_n)$;

einem Taktsignalerzeugungsmittel (61, 62), das mit den genannten Reihenauswahlschaltungen (411, 421; 412, 422) und der genannten Spaltendekoderschaltungsanordnung (31, 32) verbunden ist und betriebsfähig ist, um das genannte Reihenauswahlschaltungsaktivierungssignal (S(WD)) und das genannte Spaltendekoderaktivierungssignal (S(CD)) zu erzeugen, welches Mittel (61, 62) eine Vielzahl von Taktsignalerzeugungsschaltungen (61; 62) enthält, die mit entsprechenden Reihenauswahlschaltungen (411, 421; 412, 422) verbunden sind und individuell selektiv betriebsfähig sind, um das genannte Reihenauswahlschaltungsaktivierungssignal (S(WD)) Zu erzeugen und um jenes Signal (S(WD)) der Reihenauswahlschaltung (411, 421; 412, 422) zuzuführen, die ihnen zugeordnet ist; und

einem Blockauswahlmittel (53), das mit jeder der genannten Taktsignalerzeugungsschaltungen (61; 62) verbunden ist und angeordnet ist, um das genannte Adreßsignal $(a_0, ..., a_n)$ zu empfangen, welches Mittel zu Beginn einer Zugriffsoperation betriebsfähig ist, um in Abhängigkeit von jenem Adreßsignal $(a_0, ..., a_n)$ diejenige der Taktsignalerzeugungsschaltungen (61; 62) auszuwählen, die der Reihenauswahlschaltung (411, 421; 412, 422) dient, die dem Speicherzellenblock (11; 12) zugeordnet ist, zu dem die Speicherzelle, auf die zuzugreifen ist, gehört, welche Taktsignalerzeugungsschaltung (61; 62) dadurch veranlaßt wird, das genannte Reihenauswahlschaltungsaktivierungssignal (S(WD)) an die Reihenauswahlschaltung (411, 421; 412, 422) auszugeben, die ihr zugeordnet ist, wodurch während der genannten Zugriffsoperation nur diejenige der Reihenauswahlschaltungen (411, 421; 412, 422) aktiviert wird, die dem Speicherzellenblock (11; 12) zugeordnet ist, der die Speicherzelle enthält, auf die zuzugreifen ist;

dadurch gekennzeichnet, daß die genannte Spaltendekoderschaltungsanordnung (31, 32) eine Vielzahl von Spaltendekodern (31; 32) umfaßt, die mit den entsprechenden Speicherzellenblöcken (11; 12) verbunden sind, und daß die genannten Taktsignalerzeugungsschaltungen (61; 62) auch jeweils mit den Spaltendekodern (31; 32) verbunden sind, so daß jede derartige Schaltung (61; 62) mit dem Spaltendekoder (31; 32) und der Reihenauswahlschaltung (411, 421; 412, 422) verbunden ist, die demselben Speicherzellenblock (11; 12) zugeordnet sind, und individuell betriebsfähig sind, wenn sie durch das genannte Blockauswahlmittel (53) ausgewählt wurden, um das genannte Spaltendekoderaktivierungssignal (S(CD)) zu erzeugen und um jenes Signal (S(CD)) dem Spaltendekoder (31; 32) zuzuführen, der ihnen zugeordnet ist.

**2.** Eine Anordnung nach Anspruch 1, bei der das genannte Blockauswahlmittel (53) betriebsfähig ist, um eine Vielzahl von Auswahlsignalen (S-($\Phi_1$); S($\Phi_2$)) zum jeweiligen Zuführen zu den genannten Taktsignalerzeugungsschaltungen (61; 62) zu erzeugen, welche Auswahlsignale (S($\Phi_1$); S($\Phi_2$)) so sind, daß nur die auszuwählende Taktsignalerzeugungsschaltung (61; 62) aktiviert wird.

**3.** Eine Anordnung nach Anspruch 2, bei der das genannte Blockauswahlmittel (53) eine Vielzahl von Auswahlsignalerzeugungsschaltungenzum jeweiligen Bereitstellen der genannten Auswahlsignale (S($\Phi_1$); S($\Phi_2$)) umfaßt, wobei jede Auswahlsignalerzeugungsschaltung durch ein NAND-Gatter gebildet ist, das mit einem Inverter seriell verbunden ist.

**4.** Eine Anordnung nach Anspruch 3, bei der in jeder der Auswahlsignalerzeugungsschaltungen das genannte NAND-Gatter einen ersten Eingangsanschluß hat, der verbunden ist, um ein Operationssignal (S($\Phi$)) von einem Adressensteuergenerator (51) der Anordnung zu empfangen, und einen zweiten Eingangsanschluß, der verbunden ist, um Adreßbits ($a_0$, ..., $a_n$) von einem Adressenpuffer (52) der Anordnung zu empfangen.

**5.** Eine Anordnung nach irgendeinem vorhergehenden Anspruch, bei der jede der genannten Taktsignalerzeugungsschaltungen (61; 62) wenigstens zwei Puffer (BUFFER-2, BUFFER-3, ...) umfaßt, die seriell zusammen verbunden sind, so daß das genannte Reihenauswahlschaltungsaktivierungssignal (S(WD)) und das Spaltendekoderaktivierungssignal (S(CD)) zu vorgegebenen Zeiten an entsprechenden Ausgangsknoten der genannten Puffer (BUFFER-2, BUFFER-3, ...) bereitgestellt werden.

**6.** Eine Anordnung nach irgendeinem vorhergehenden Anspruch, bei der jede der genannten Taktsignalerzeugungsschaltungen (61; 62) auch betriebsfähig ist, um Taktsignale zur Verwendung in einer Eingangs-/Ausgangs-Schaltungsanordnung (81/82) und einer Leseverstärkerschaltungsanordnung (21; 22) der Anordnung zu erzeugen.

**Revendications**

**1.** Dispositif de mémoire à semiconducteur comprenant :

un réseau de cellules de mémoire divisé en une pluralité de blocs de cellules de mémoire (11 ; 12) ;

une pluralité de circuits de sélection de rangée (411, 421 ; 412, 422) connectés de manière opérationnelle à des blocs de cellules de mémoire respectifs (11 ; 12) et agencés pour recevoir un signal d'adresse ($a_0$, ..., $a_n$) indicatif d'une cellule de mémoire qui doit être accédée pendant une opération d'accès ;

un circuit de décodeur de colonne (31, 32) connecté de manière opérationnelle à ladite pluralité de blocs de cellules de mémoire (11 ; 12) et agencé pour recevoir ledit signal d'adresse ($a_0$, ..., $a_n$) ;

le circuit de sélection de rangée (411, 421 ; 412, 422) qui est associé au bloc de cellules de mémoire (11 ; 12) contenant la cellule de mémoire qui doit être accédée et ledit circuit de décodeur de colonne (31, 32) qui peuvent être actionnés, suite à la réception respectivement d'un signal d'activation de circuit de sélection de rangée (S(WD)) et d'un signal d'activation de décodeur de colonne (S(CD)) pour sélectionner respectivement, en relation avec ledit signal d'adresse ($a_0$, ..., $a_n$), une rangée et une colonne dans ledit bloc de cellules de mémoire (11 ; 12) ;

un moyen de génération de signal d'horloge (61, 62) connecté auxdits circuits de sélection de rangée (411, 421 ; 412, 422) et audit circuit de décodeur de colonne (31, 32) et pouvant fonctionner pour générer ledit signal d'activation de circuit de sélection de rangée (S(WD)) et ledit signal d'activation de décodeur de colonne (S(CD)), lequel moyen (61, 62) inclut une pluralité de circuits de génération de signal d'horloge (61 ; 62) connectés à des circuits de sélection de rangée respectifs (411, 421 ; 412, 422) et pouvant fonctionner sélectivement individuellement pour produire ledit signal d'activation de circuit de sélection de rangée (S(WD)) et pour appliquer ce signal (S-(WD)) au circuit de sélection de rangée (411, 421 ; 412, 422) qui lui est associé ; et

un moyen de sélection de bloc (53) connecté à chacun desdits circuits de génération de signal d'horloge (61 ; 62) et agencé pour recevoir ledit signal d'adresse ($a_0$, ..., $a_n$), ledit moyen pouvant fonctionner au commencement d'une opération d'accès pour sélectionner, d'une façon dépendante du signal d'adresse ($a_0$, ..., $a_n$), celui des circuits de génération de signal d'horloge (61 ; 62) qui dessert le circuit de sélection de rangée (411, 421 ; 412, 422) associé au bloc de cellules de mémoire (11 ; 12) auquel la cellule de mémoire qui doit être accédée appartient, lequel circuit de génération de signal d'horloge (61 ; 62) est ainsi amené à délivrer ledit signal d'activation de circuit de sélection de rangée (S(WD)) au circuit de sélection de rangée (411, 421 ; 412, 422) qui lui est associé, d'où l'activation pendant ladite opération d'accès de seulement celui des circuits de sélection de rangée (411, 421 ; 412, 422) qui est associé au bloc de cellules de mémoire (11 ; 12) contenant la cellule de mémoire qui doit être accédée,

caractérisé en ce que ledit circuit de décodeur de colonne (31, 32) comprend une pluralité de décodeurs de colonne (31 ; 32) connectés à des blocs de cellules de mémoire respectifs (11 ; 12) et en ce que lesdits circuits de génération de signal d'horloge (61 ; 62) sont également connectés respectivement aux décodeurs de colonne (31 ; 32) de telle sorte que chacun de ces circuits (61 ; 62) soit connecté au décodeur de colonne (31 ; 32) et au circuit de sélection de rangée (411, 421 ; 412, 422) associé au même bloc de cellules de mémoire (11; 12) et puisse être activé individuellement lorsqu'il est sélectionné par ledit moyen de sélection de bloc (53) pour produire ledit signal d'activation de décodeur de colonne (S(CD)) et pour appliquer ce signal (S(CD)) au décodeur de colonne (31 ; 32) qui lui est associé.

2. Dispositif selon la revendication 1, dans lequel ledit moyen de sélection de bloc (53) peut être actionné pour produire une pluralité de signaux de sélection (S($\phi_1$) ; S($\phi_2$)) afin de les délivrer respectivement auxdits circuits de génération de signal d'horloge (61 ; 62), lesquels signaux de sélection (S($\phi_1$) ; S($\phi_2$)) sont tels que seulement le circuit de génération de signal d'horloge (61 ; 62) qui doit être sélectionné est activé.

3. Dispositif selon la revendication 2, dans lequel ledit moyen de sélection de bloc (53) comprend une pluralité de circuits de génération de signal de sélection pour produire respectivement lesdits signaux de sélection (S($\phi_1$) ; S($\phi_2$)), chaque circuit de génération de signal de sélection étant constitué par une porte NON-ET connectée en série à un inverseur.

4. Dispositif selon la revendication 3, dans lequel, dans chacun des circuits de génération de signal de sélection, ladite porte NON-ET comporte une première borne d'entrée connectée pour recevoir un signal de fonctionnement (S($\phi$)) depuis un générateur de pilotage d'adresse (51) du dispositif et une seconde borne d'entrée connectée pour recevoir des bits d'adresse ($a_0$, ..., $a_n$) depuis un tampon d'adresse (52) du dispositif.

5. Dispositif selon l'une quelconque des revendications précédentes, dans lequel chacun desdits circuits de génération de signal d'horloge (61 ; 62) comprend au moins deux tampons (TAMPON-2, TAMPON-3, ...) connectés ensemble en série de telle sorte que ledit signal d'activation de circuit de sélection de rangée (S(CD)) et que ledit signal d'activation de décodeur de colonne (S(CD)) soient produits à des instants pré-établis au niveau de noeuds de sortie respectifs desdits tampons (TAMPON-2, TAMPON-3, ...).

6. Dispositif selon l'une quelconque des revendications précédentes, dans lequel chacun desdits circuits de génération de signal d'horloge (61 ; 62) peut également fonctionner pour produire des signaux d'horloge destinés à être utilisés dans un circuit d'entrée/sortie (81/82) et dans un circuit d'amplificateur de détection (21 ; 22) du dispositif.

## Fig. 1A

S($\overline{CE}$)

6A
ADDRESS DRIVE GENERATOR

6B
BLOCK SELECTOR

Fig. 1

| Fig. 1A | Fig. 1B |

S(AD)

S(WD)     S(WD)

52
ADDRESS BUFFER

$A_0$ $a_0$ $\overline{a}_0$
$A_1$ $a_1$ $\overline{a}_1$
$A_2$ $a_2$ $\overline{a}_2$
⋮
$A_n$ $a_n$ $\overline{a}_n$

421
ROW DECODER

411
WORD DRIVER

422
ROW DECODER

412
WORD DRIVER

EP 0 249 413 B1

Fig. I B

CLOCK GENERATOR

S(OB)
S(CD)
S(LE)
S(WD)
S(AD)

WRITE CLOCK GENERATOR

S(WE)

S(7)

COLUMN DECODER ~ 31
SENSE AMPLIFIER & INPUT/OUTPUT ~ 21
CELL BLOCK No. 1 ~ 11

D(IN) BUFFER

S(D·IN)

COLUMN DECODER ~ 32
SENSE AMPLIFIER & INPUT/OUTPUT ~ 22
CELL BLOCK No. 2 ~ 12

D(OUT) BUFFER

S(D·OUT)

EP 0 249 413 B1

## Fig. 2

BUFFER-1  BUFFER-2  BUFFER-3  BUFFER-4          BUFFER-X

$S(\overline{CE})$

$C_1$  $C_2$  $C_3$          $C_x$

$S(AD)$  $S(WD)$  $S(LE)$          $S(OB)$

## Fig. 5

53

BLOCK SELECTOR

$S(\phi)$

$a_n$

$S(\phi_1)$

$S(\phi)$

$\overline{a}_n$

$S(\phi_2)$

EP 0 249 413 B1

Fig. 3

| Fig. 3 A | Fig. 3 B |

Fig. 3 A

S($\overline{CE}$) → 51 ADDRESS DRIVE GENERATOR → S($\phi$) → 53 BLOCK SELECTOR → S($\phi_2$), S($\phi_1$)

S(AD)

52 ADDRESS BUFFER

$A_0$ $A_1$ $A_2$ ⋯ $A_n$ → $a_0$ $\overline{a}_0$ $a_1$ $\overline{a}_1$ $a_2$ $\overline{a}_2$ $a_n$ $\overline{a}_n$

421 ROW DECODER | 411 WORD DRIVER

422 ROW DECODER | 412 WORD DRIVER

Fig. 3B

EP 0 249 413 B1

# Fig. 4

S(CE̅) → ADDRESS DRIVE GENERATOR [51] → BLOCK SELECTOR [53] →

**CLOCK GENERATOR No.1** [61]
BUFFER-2, BUFFER-3, BUFFER-X
$C_2$ → S(WD), $C_3$ → S(LE), $C_x$ → S(OB)

**CLOCK GENERATOR** [62]
BUFFER-2′, BUFFER-3′, BUFFER-X
$C_2$ → S(WD), $C_3$ → S(LE), $C_x$ → S(OB)

EP 0 249 413 B1

EP 0 249 413 B1

# Fig. 6

Fig. 7
| Fig. 7A | Fig. 7B |

Fig. 7A

EP 0 249 413 B1

# Fig. 7B

CLOCK GEN. No.1n

ROW DECODER | WORD DRIVER

CELL BLOCK No.1n

SENSE AMP & I/O

COLUMN DEC.

CLOCK GEN. No. mn

ROW DECODER | WORD DRIVER

CELL BLOCK No. mn

SENSE AMP & I/O

COLUMN DEC.

WRITE CLOCK GENERATOR

7

D (IN ) BUFFER

81

D (OUT) BUFFER

82

EP 0 249 413 B1